# EUROPÄISCHE PATENTANMELDUNG

(11) **EP 4 852 636 A1**
(43) Veröffentlichungstag der Anmeldung: **09.12.2026**
(21) Anmeldenummer: 26165528.6
(22) Anmeldetag: 17.03.2026
(51) Int. Cl.: H05K 7/20

(54) **SYSTEM ZUR KÜHLUNG EINES RECHENZENTRUMS**

(30) Priorität: 17.03.2025 DE 102025110217; 30.05.2025 US 202519224256
(71) Anmelder: Kohl, Edwin, 66663 Merzig (DE)
(72) Erfinder: Kohl, Edwin, 66663 Merzig (DE)
(74) Vertreter: Betten & Resch

(57) **Zusammenfassung**

Die vorliegende Erfindung offenbart ein System zur Kühlung eines Rechenzentrums, insbesondere eines KI-Rechenzentrums mit einer Vielzahl von Rechnermodulen (10) mit Halbleiterbauelementen, welche im Betrieb eine Wärmequelle darstellen, aufweisend: eine Kühleinrichtung zur Kühlung der Rechnermodule (10) mittels eines Kühlmittelfluidkreislaufs, wobei die Kühleinrichtung eine Adsorptionskühlvorrichtung (50) mit einem Verdampfer (V), einem Kondensator (K), und wenigstens zwei Adsorptions-/Desorptionselementen (Ads/Des) für das Kühlmittelfluidum aufweist, wobei der Kondensator (K) eine thermische Schnittstelle (51) zur Abgabe von Wärme an ein Reservoir (56) aufweist, und eine Kältespeichereinrichtung (60), die über eine erste thermische Schnittstelle (61) steuerbar thermisch mit dem Verdampfer (V) der Adsorptionskühlvorrichtung (50) zur Pufferspeicherung eines Teils der von dem Verdampfer (V) abgegebenen Kälte gekoppelt ist, und über eine zweite thermische Schnittstelle (62) steuerbar thermisch mit dem Kondensator (K) der Adsorptionskühlvorrichtung (50) zur Abgabe gespeicherter Kälte an den Kondensator (K) gekoppelt ist.

## Beschreibung

### TECHNISCHES GEBIET DER VORLIEGENDEN OFFENBARUNG

Die vorliegende Offenbarung bezieht sich auf ein System zur Kühlung eines Rechenzentrums.

### HINTERGRUND DER ERFINDUNG

Aufgrund der hohen und ständig steigenden Nachfrage hat sich der Bedarf an Rechenleistung in Rechenzentren stark entwickelt. Dabei spielen die zunehmende Digitalisierung von Wirtschaft und Gesellschaft, die rasante Entwicklung von Cloud-Computing und in den letzten Jahren insbesondere der zunehmende Einsatz von künstlicher Intelligenz (Kl) und maschinellem Lernen eine große Rolle. Die Entwicklung und Anwendung von KI und maschinellem Lernen erfordert enorme Rechenressourcen, insbesondere für das Training von KI Modellen. Diese Technologien beeinflussen massiv die Rechenzentren, da sie spezialisierte Hardware wie Graphikprozessoren (GPUs) und Tensorprozessoren (TPUs) benötigen, die viel leistungsfähiger als herkömmliche Mikroprozessoren (CPUs) sind, dadurch jedoch auch mehr Strom verbrauchen und mehr Wärme abgeben.

Rechenzentren erzeugen durch die hohe Rechenleistung und den Betrieb von Tausenden von Servern eine enorme Wärme, die effizient abgeführt werden muss, um die Hardware vor Überhitzung zu schützen und einen stabilen Betrieb zu gewährleisten. Es gibt verschiedene Methoden, um Rechenzentren zu kühlen, wie etwa Luftkühlung, Wasserkühlung oder Immersionskühlung, wobei Server oder andere IT-Komponenten direkt in ein spezielles, nicht leitendes Kühlmittel eingetaucht werden. Das Kühlmittel leitet die Wärme effizient ab, wodurch der Umfang der Luft- oder Wasserkühlung verringert wird.

Die Bauelemente in Rechenzentren, insbesondere Server, Prozessoren und andere elektronische Komponenten, erzeugen bei ihrem Betrieb unterschiedliche Temperaturen. Die genaue Temperatur hängt von der Art des Bauelements, der Arbeitsbelastung und den Kühlmethoden ab. Im Allgemeinen gilt, dass die Komponenten in Rechenzentren nicht zu heiß werden dürfen, um Schäden oder Leistungseinbußen zu vermeiden. Typische Temperaturbereiche für Prozessoren (CPUs und GPUs) liegen zwischen 30°C und 50°C im Leerlaufbetrieb und 60°C bis 70°C bei Vollauslastung. In Kl-Rechenzentren ist der höhere Temperaturbereich typisch. Andere elektronische Komponenten wie Speicher oder Netzwerkkomponenten arbeiten bei niedrigeren Betriebstemperaturen von etwa 30°C bis 50°C.

Die Kühlung von Rechenzentren bleibt eine große Herausforderung, da sie sowohl für die Leistung als auch für die Energieeffizienz und die Klimabilanz eines Rechenzentrums entscheidend ist.

### ZUSAMMENFASSUNG DER ERFINDUNG

Die Erfindung ist durch die unabhängigen Ansprüche definiert. Abhängige Ansprüche beschreiben weitere Ausführungsformen der Erfindung.

Erfindungsgemäß wird ein System zur Kühlung eines Rechenzentrums vorgeschlagen, welches eine Vielzahl von Rechnermodulen mit Halbleiterbauelementen aufweist, welche Halbleiterbauelemente im Betrieb eine Wärmequelle darstellen, aufweisend:
eine Kühleinrichtung zur Kühlung der Rechnermodule mittels eines Kühlmittelfluidkreislaufs, wobei die Kühleinrichtung eine Adsorptionskühlvorrichtung mit einem Verdampfer, einem Kondensator, und einem oder mehreren Adsorptions-/Desorptionselementen für das Kühlmittelfluidum aufweist, wobei der Kondensator eine thermische Schnittstelle zur Abgabe von Wärme an ein thermisches Reservoir aufweist, und eine Kältespeichereinrichtung, die steuerbar thermisch mit der Adsorptionskühlvorrichtung zur Pufferspeicherung von der Adsorptionskühlvorrichtung abgegebener Kälte gekoppelt ist.

Die Erfindung basiert auf der Kombination einer oder mehreren Adsorptionskältemaschinen, die hervorragend zur Kühlung im Temperaturbereich von 55°C bis 70°C geeignet sind, mit einer Eirichtung zur Speicherung bzw. Pufferung von Kälte, die zur Handhabung von Leistungs- und/oder Temperaturspitzen herangezogen werden kann. Die Vorrätighaltung einer Kältereserve ermöglicht Ersparnisse bei der Auslegung des gesamten Kühlsystems, dessen Maximalleistung geringer bemessen werden kann. Die Kältespeicherung ermöglicht außerdem, auf Strompreisschwankungen zu reagieren und durch Rückgriff auf gespeicherte Kälte den Stromverbrauch des Kühlsystems kurzfristig zu reduzieren.

Dabei kann die Kältespeichereinrichtung als PCM Kältespeicher ausgelegt sein, der eine effiziente Kältespeicherung in den vorgegebenen Temperaturbereichen ermöglicht. Das thermische Reservoir der Adsorptionskühlvorrichtung kann dabei mit einer zweiten Kältespeichervorrichtung gekoppelt sein.

Weiterhin kann die Kältespeichereinrichtung einen thermischen Gebäudekernspeicher, einen Erdkältespeicher, einen Flüssigkeitsspeicher, und/oder ein Nah- oder Fernkältenetz umfassen.

Gemäß manchen Ausführungsbeispielen kann der Erdkältespeicher, thermische Gebäudekernspeicher, Flüssigkeitskältespeicher, und/oder das Nah- oder Fernkältenetz in Abhängigkeit von der Außentemperatur thermisch mit dem thermischen Reservoir und/oder der Adsorptionskühlvorrichtung koppelbar sein. Somit kann beispielsweise in einem Winterbetrieb ein erheblicher Teil der Kühlleistung durch Umgebungskälte erbracht werden, wodurch der Energieverbrauch des Rechenzentrums weiter verringert werden kann.

Weiterhin können die Adsorptions-/Desorptionselemente der Adsorptionskühlvorrichtung regelbar thermisch mit einer solarthermischen Heizvorrichtung zur thermischen Unterstützung des Desorptionsvorgangs gekoppelt sein. Damit kann der Energieverbrauch des Rechenzentrums durch die Nutzung von Sonnenenergie ebenfalls weiter verringert werden.

In einem Ausführungsbeispiel ist die solarthermische Heizvorrichtung konfigurierbar, in Abhängigkeit von der Außentemperatur in einem Kühlmodus als Kältequelle zu arbeiten. Dabei kann die solarthermische Heizvorrichtung im Kühlmodus thermisch mit dem Adsorber und/oder dem Kältereservoir koppelbar sein.

Gemäß manchen Ausführungsbeispielen sind die Adsorptions-/Desorptionselemente der Adsorptionskühlvorrichtung thermisch mit den Rechnermodulen des Rechenzentrums gekoppelt, wobei die von den Rechnermodulen abgegebene Wärme zur Desorption des Kühlmittelfuids eingesetzt wird. Der Temperaturbereich leistungsstarker KI-Prozessoren im Bereich oberhalb von 55°C eignet sich optimal zur Desorption des Kühlmittels wie etwa Wasser.

Gemäß manchen Ausführungsbeispielen sind die Adsorptions-/Desorptionselemente der Adsorptionskühlvorrichtung über mittels Wärmetauschern über einen Hochtemperaturkühlkreislauf thermisch mit den Rechnermodulen des Rechenzentrums gekoppelt, wobei die Temperatur des von den Rechnermodulen zum Adsorptionselement Ads zurückfließenden Wärmeaustauschmediums wenigstens 50°C, vorzugsweise wenigstens 55°C, und noch bevorzugter wenigstens 60°C beträgt.

Gemäß manchen Ausführungsbeispielen sind die Adsorptions- und Desorptionselemente der Adsorptionskühlvorrichtung für einen kontinuierlichen Kühlbetrieb im Wechsel zyklisch thermisch mit den Rechnermodulen des Rechenzentrums koppelbar.

Der Verdampfer der Adsorptionskühlvorrichtung kann thermisch mit Funktionsmodulen des Rechenzentrums gekoppelt sein, die eine niedrigere Arbeitstemperatur als die Rechnermodule aufweisen, wie etwa Speicher- oder Kommunikationsbauelemente.

Das Kühlmittelfluid der Adsorptionskühlvorrichtung ist beispielsweise Wasser.

Das Sorptionsmittel der Adsorptionskühlvorrichtung kann dabei Zeolith oder Silikagel sein.

Das PCM-Material des PCM Speichers kann Wasser, Salzlösungen oder Paraffine umfassen.

Die Erfindung bezieht sich außerdem auf ein Rechenzentrum aufweisend ein Kühlsystem nach einem der vorangehenden Patentansprüche.

### KURZBESCHREIBUNG DER ZEICHNUNGEN

Figur 1 zeigt eine schematische Darstellung eines ersten Ausführungsbeispiels eines erfindungsgemäßen Systems zur Kühlung eines Rechenzentrums.
Figur 2 zeigt eine schematische Darstellung eines zweiten Ausführungsbeispiels eines erfindungsgemäßen Systems zur Kühlung eines Rechenzentrums.
Figur 2a zeigt eine schematische Darstellung einer Variante des in Figur 2 dargestellten erfindungsgemäßen Systems zur Kühlung eines Rechenzentrums.
Figur 2b zeigt eine schematische Darstellung einer weiteren Variante des in Figur 2 dargestellten erfindungsgemäßen Systems zur Kühlung eines Rechenzentrums.
Figur 3 zeigt eine schematische Darstellung eines dritten Ausführungsbeispiels eines erfindungsgemäßen Systems zur Kühlung eines Rechenzentrums.
Figur 4 illustriert die Einspeicherung von Kälte bei dem erfindungsgemäßen System zur Kühlung eines Rechenzentrums gemäß Figur 3.
Figur 5 illustriert die Ausspeicherung von Kälte bei dem erfindungsgemäßen System zur Kühlung eines Rechenzentrums gemäß Figur 3.
Figur 6 zeigt eine schematische Darstellung eines vierten Ausführungsbeispiels eines erfindungsgemäßen Systems zur Kühlung eines Rechenzentrums.
Figur 7 illustriert einen ersten Teilzyklus einer an sich bekannten Adsorptionskältemaschine.
Figur 8 illustriert einen zweiten Teilzyklus einer an sich bekannten Adsorptionskältemaschine.

### DETAILLIERTE BESCHREIBUNG

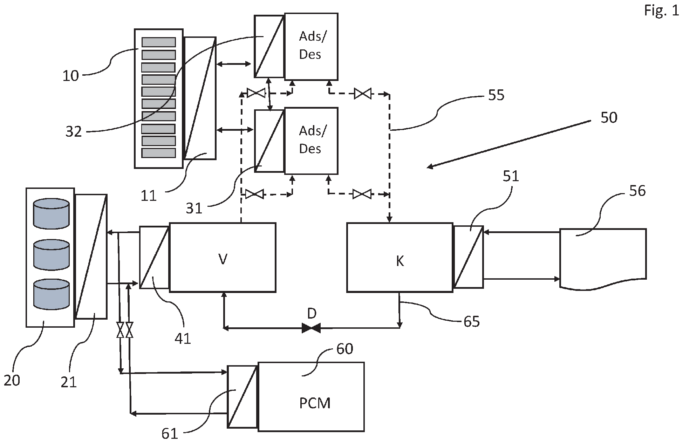

Im Folgenden wird auf beispielhafte Ausführungsformen der Offenbarung Bezug genommen, die in den beigefügten Zeichnungen dargestellt sind. Wo immer es möglich ist, werden in den Zeichnungen dieselben Bezugszeichen verwendet, um sich auf gleiche oder ähnliche Entitäten zu beziehen. Darüber hinaus gelten die im Zusammenhang mit einer bestimmten Ausführungsform, z. B. der in Fig. 1 dargestellten, erläuterten Merkmale und technischen Effekte auch für alle anderen Ausführungsformen, sofern nichts anders beschrieben ist. Falls nicht anders angegeben, können Merkmale und Effekt verschiedener Ausführungsformen passend kombiniert werden.

### Adsorptionskältemaschinen

Adsorptionskältemaschinen sind thermisch betriebene Kältemaschinen. Sie nutzen ein festes Sorptionsmittel, wie z.B. Aktivkohle, Zeolith oder Silikagel, um mit Hilfe eines sorptiven Prozesses ein Kältemittel zu verdichten. Das Sorptionsmittel befindet sich in einem Apparat, der als Adsorber und Desorber im zeitlichen Wechsel fungiert.

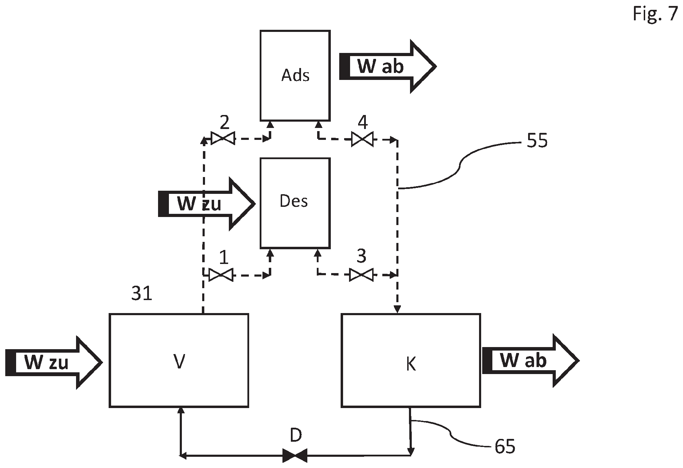

Eine Adsorptionskältemaschine, wie sie etwa aus der WO 2017/174235 bekannt ist, ist schematisch in Fig. 7 dargestellt und besteht im Wesentlichen aus einem Verdampfer V, einem Adsorber Ads, einem Desorber Des, einem Kondensator K und einer Drossel D. Da zwei Adsorber/Desorber vorgesehen sind, kann der Kühlprozess kontinuierlich, d. h. ohne Unterbrechung, betrieben werden.

Das Arbeitsmedium, beispielsweise Wasser, wird in der Adsorbereinrichtung Ads an einem festen Adsorbens adsorbiert. Durch den dadurch erzeugten Unterdruck geht das Arbeitsmedium im Verdampfer V in einen gasförmigen Zustand über. Der Verdampfer V nimmt dabei Wärme aus der Umgebung auf (Pfeil "W zu") und kann daher zur Kühlung eingesetzt werden.

Parallel wird das Arbeitsmedium aus dem Desorber Des durch Zufuhr externer Wärme (Pfeil "W zu") ausgetrieben. Das Arbeitsmedium gelangt dann im gasförmigen Zustand in den Kondensator K und wird dort verflüssigt. Dabei gibt es die am Verdampfer V aufgenommene Wärme zusammen mit der am Desorber Des zugeführten Wärme am Kondensator K wieder ab (Pfeil "W ab"). Das Arbeitsmedium gelangt dann über einen Rücklauf in flüssiger Form in den Verdampfer V zurück. Dadurch schließt sich der Arbeitskreislauf der Adsorptionskältemaschine. Die Vorrichtung arbeitet somit als Wärmepumpe, wobei keine Lüfter oder anderen beweglichen Teile erforderlich sind, wodurch die Adsorptionskältemaschine sehr effizient arbeiten und wartungsarm betrieben werden kann.

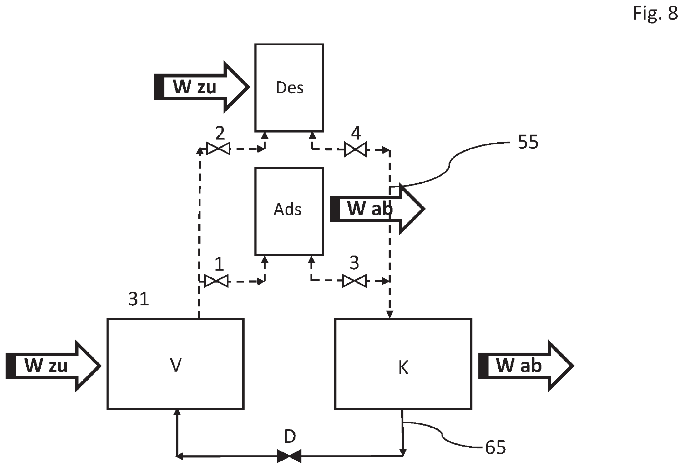

Ist der Adsorber Ads mit dem Arbeitsmedium gesättigt, erfolgt die Umschaltung in den zweiten Teil des Arbeitszyklus, der in Figur 8 illustriert ist.

Ventil 2 wird geschlossen und Ventil 4 wird geöffnet, wobei der bisherige Adsorber Ads zum Desorber Des wird. Gleichzeitig wird Ventil 1 geöffnet und Ventil 3 geschlossen, so dass der bisherige Desorber zum Adsorber Ads wird.

Der zwischen Verdampfer V, Adsorber/Desorber und Kondensator K gebildete Arbeitskreislauf enthält den Abschnitt 55 (gestrichelt), in dem das Arbeitsmedium in gasförmiger Form vorliegt und einen Abschnitt 65, in welchem das Arbeitsmedium in flüssiger Form vorliegt.

Das Arbeitsmedium innerhalb des Flüssighalbkreises 55 kann mit einem geeigneten Funktionsmedium gemischt sein, das unterschiedliche Aufgaben ausführen kann, wie eine Dampfdrucksenkung des Arbeitsmediums während des Verdampfungsvorgangs im Verdampfer V.

### PCM (Phase change material) Speicher

Eine Kältespeichereinrichtung, die auf Phase Change Materials (PCM) bzw. Phasenwechselmaterialien basiert und auch als Latentkältespeicher bezeichnet wird, nutzt die Fähigkeit von Stoffen, bei Temperaturänderungen beispielsweise zwischen festem und flüssigem Zustand zu wechseln und dabei durch diesen Phasenwechsel Wärme zu speichern bzw. abzugeben.

PCM Kältespeicher nutzen dabei Materialien, die bei einer im geeigneten Temperaturbereich liegenden Temperatur von dem einem Zustand in den anderen übergehen - zum Beispiel von fest zu flüssig. Während dieses Phasenwechsels wird eine große Menge an Wärmeenergie aufgenommen bzw. freigesetzt, ohne dass sich die Temperatur des Materials signifikant verändert. Diese Form der bei einer Phasenumwandlung freiwerdenden Wärmeenergie wird als latente Wärme bezeichnet. Beim Schmelzen von Eis oder Gefrieren von Wasser liegt die Temperatur bei Atmosphärendruck beispielsweise ziemlich konstant bei 0⁰C und kochendes Wasser hat eine konstante Temperatur von 100°C.

Der Hauptvorteil dieser Technik liegt darin, dass sie latente Wärme speichert - also die Wärme, die während eines Phasenwechsels (zum Beispiel von fest zu flüssig) aufgenommen oder abgegeben wird, ohne die Temperatur des Materials direkt zu verändern.

Ein häufig genutztes Material ist Paraffin, das bei einer Temperatur von etwa 20°C bis 30°C schmilzt. Wenn es in einem Latentkältespeicher verwendet wird, kann es überschüssige Wärme absorbieren und speichern, während es vom festen in den flüssigen Zustand übergeht. Wenn die Temperatur sinkt, gibt es diese gespeicherte Wärme wieder ab, wenn es vom flüssigen wieder in den festen Zustand übergeht.

Die Vorteile eines PCM Kältespeichers umfassen:
- Energieeffizienz: PCM Kältespeicher bieten eine hohe Energieeffizienz, weil sie eine große Menge an Wärmeenergie speichern können, ohne dass sich ihre Temperatur wesentlich verändert. Das bedeutet, dass sie bei Bedarf eine konstante Kühlung liefern können, ohne ständig Kühlmittelnachschub zu benötigen oder zusätzliche Energie zu verbrauchen.
- Raumeffizienz: Diese Art der Kühlung benötigt weniger Raum und weist eine geringere apparative Komplexität auf als herkömmliche Systeme mit Verdampfern oder großen Kältemaschinen, da die gespeicherte Energie in Form von latenter Wärme kompakt im Material selbst gespeichert wird.
- Kontinuierliche Kühlung: Da PCM Kältespeicher Wärme effizient über längere Zeiträume speichern können, bieten sie die Möglichkeit einer gleichmäßigen Kühlung ohne Schwankungen, was besonders in Bereichen wie Rechenzentren, medizinischen Einrichtungen oder in der Lebensmittelindustrie von Vorteil ist.
- Nachhaltigkeit: Die Verwendung von Phasenwechselmaterialien zur Kühlung kann die Umweltauswirkungen reduzieren, da weniger mechanische Kühlgeräte benötigt werden und weniger Kältemittel (die oft klimaschädlich sind) zum Einsatz kommen.

Latentkältespeicher bieten so eine effektive und nachhaltige Lösung für das Kühlen in verschiedenen Anwendungen. Durch die Fähigkeit, große Mengen an Wärmeenergie effizient zu speichern und wieder freizusetzen, stellen sie eine vielversprechende Technologie dar.

### Ausführungsbeispiele der Erfindung

Figur 1 zeigt schematisch ein erstes Ausführungsbeispiel eines erfindungsgemäßen Systems zur Kühlung eines Rechenzentrums.

Die Funktionsweise der Adsorptionskühlvorrichtung 50 entspricht dabei im Grundsatz der in Figuren 7 und 8 beschriebenen Adsorptionskühlvorrichtung.

Die Adsorptionskühlvorrichtung 50 gemäß Figur 1 weist einem Verdampfer V, zwei Adsorber/Desorber Ads/Des, einen Kondensator K und eine Drossel D auf. Da wiederum zwei Adsorber/Desorber vorgesehen sind, kann der Kühlprozess quasikontinuierlich, d. h. ohne Unterbrechung, betrieben werden.

Die beiden Adsorber/Desorber Ads/Des sind dabei über Wärmetauscher 31, 32 in einem Kühlkreislauf mit dem Wärmetauscher 11 eines Rechnermoduls 10 verbunden, welches beispielsweise die Hochleistungsprozessoren (CPUs, TPUs oder GPUs) eines KI-Rechenzentrums enthalten, die in Volllast große Wärmemengen abgeben. Dabei handelt es sich vorzugsweise um einen Hochtemperaturkühlkreislauf, bei dem die von den Prozessoren abgegebene Wärme genutzt wird, um die Desorption des Arbeitsmediums (vorzugsweise Wasser) im Kreislauf der Adsorptionskühlvorrichtung 50 zu bewirken. Die Vorlauftemperatur des Hochtemperaturkühlkreislaufes 31, 32, 11 beträgt dabei beispielsweise mindestens 60°C, die Rücklauftemperatur beispielsweise mindestens 55°C. Somit können einerseits die Prozessoren des Rechnermoduls 10 auf einer konstanten Temperatur gehalten und andererseits die Desorption des Arbeitsmediums der Adsorptionskühlvorrichtung 50 effizient durchgeführt werden.

Der Verdampfer V, welcher Kälte abgibt, ist über einen Kühlkreislauf umfassend die Wärmetauscher bzw. thermischen Schnittstellen 21, 41 mit einem weiteren Funktionsmodul 20 des Rechenzentrums verbunden, welches Funktionsmodul 20 elektronische Bauelemente wie Speicherelemente oder Netzwerkkomponenten enthält, die eine niedrigere Betriebstemperatur (beispielsweise 30°C bis 45°C oder auch 18°C bis 23°C) aufweisen als die Prozessoren des Moduls 10. Bei dem Kühlkreislauf 21, 41 handelt es sich somit um einen Niedertemperaturkühlkreislauf. Die Rücklauftemperatur vom Modul 20 beträgt dabei beispielsweise 25°C, die Vorlauftemperatur zum Modul beispielsweise 20°C oder 15°C.

Kühlkreislauf 21, 41 weist eine über Ventile steuerbare Abzweigung zum Wärmetauscher 61 einer Kältespeichereinrichtung 60 auf, die in dem in Figur 1 gezeigten Ausführungsbeispiel als PCM Kältespeicher oder Latentkältespeicher ausgebildet ist, der - wie oben erläutert - die Kälte mittels eines Phasenübergangs eines geeigneten Kältespeichermaterials wie etwa Wasser, Salzlösungen oder Paraffine speichert.

Im Kondensator K kondensiert das Arbeitsmedium, wobei Wärme frei wird, die an ein Kältereservoir 56 abgegeben wird.

Der zwischen Verdampfer V, Adsorber/Desorber und Kondensator K gebildete Arbeitskreislauf enthält einen Abschnitt 55 (gestrichelt), in dem das Arbeitsmedium in gasförmiger Form vorliegt und einen Abschnitt 65, in welchem das Arbeitsmedium in flüssiger Form vorliegt.

Das Arbeitsmedium innerhalb des Flüssighalbkreises 55 kann mit einem geeigneten Funktionsmedium gemischt sein, das unterschiedliche Aufgaben ausführen kann, wie eine Dampfdrucksenkung des Arbeitsmediums während des Verdampfungsvorgangs im Verdampfer V.

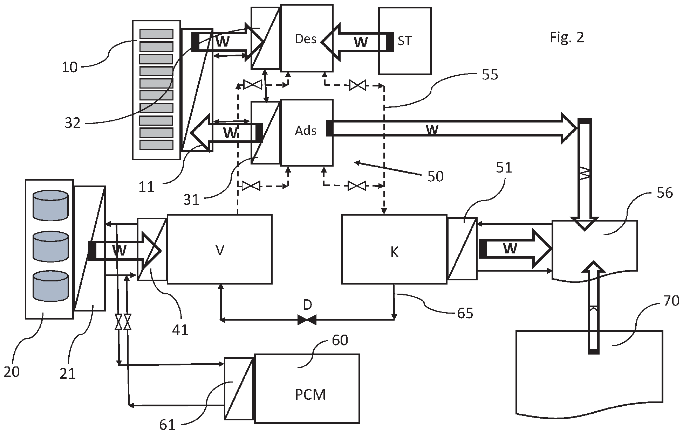

Figur 2 zeigt eine schematische Darstellung eines zweiten Ausführungsbeispiels eines erfindungsgemäßen Systems zur Kühlung eines Rechenzentrums. Dieses weist zusätzlich eine solarthermische Heizvorrichtung ST auf, die zur Unterstützung des Desorptionsvorgangs mit dem jeweiligen Desorber kopppelbar ist und zur weiteren Energieeinsparung nutzbar ist.

Figur 2a zeigt eine Variante des Ausführungsbeispiels der Figur 2. Eine automatische Parallel- und Reihenverschaltung innerhalb der Adsorptionskaskade 31a, 32a ermöglicht je nach Solarangebot gleichbleibende Rücklauftemperaturen. Bei großen Temperaturdifferenzen dT werden die Elemente der Adsorptionskaskade in Reihe geschaltet und bei kleinen Temperaturdifferenzen parallel geschaltet.

Figur 2b zeigt eine weitere Variante des Ausführungsbeispiels der Figur 2. Bei diesem Ausführungsbeispiel ist die solarthermische Heizvorrichtung ST konfigurierbar, in Abhängigkeit von der Außentemperatur - beispielsweise im Winter - in einem Kühlmodus als Kältequelle zu arbeiten. Dazu ist in dem gezeigten Ausführungsbeispiel die solarthermische Heizvorrichtung ST im Kühlmodus thermisch mit dem Kältereservoir 56 gekoppelt, um die die Rückkühlung des Gesamtsystems zu unterstützen. Alternativ oder zusätzlich kann die solarthermische Heizvorrichtung ST im Kühlmodus auch thermisch mit dem Ads Adsorber der Adsorptionskühlvorrichtung 50 gekoppelt sein. Die Solathermieanlage ST kann somit auch im Winter zur Effizienzsteigerung der Gesamtanlage eingesetzt werden. Als Kühlmedium der solarthermischen Heizvorrichtung ST im Kühlmodus können dabei geeignete Fluide wie beispielsweise Wasser, mit Frostschutzmittel (Glykol) versetztes Wasser, Alkohole oder technische Öle eingesetzt werden.

Als weitere Variante ist es möglich, die solarthermische Heizvorrichtung ST räumlich zur Verschattung des Erdkältespeichers einzusetzen, um die Kühleffizienz weiter zu verbessern.

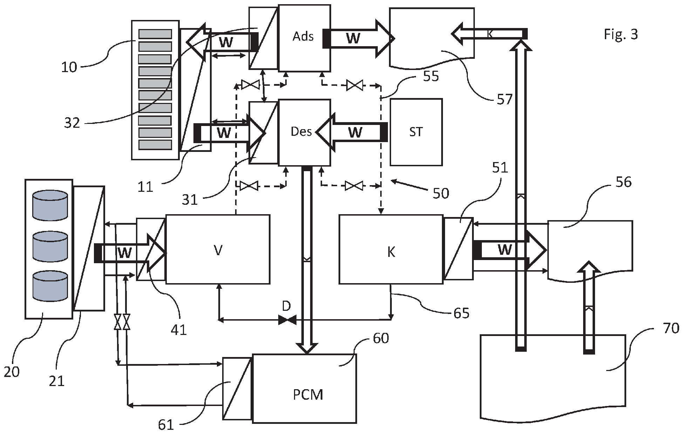

Figur 3 zeigt eine schematische Darstellung eines dritten Ausführungsbeispiels eines erfindungsgemäßen Systems zur Kühlung eines Rechenzentrums. Dieses weist eine zweite Kältespeichervorrichtung 70 auf, in dem die Kälte beispielsweise im Betonkern eines Gebäudes oder in einem Erdkältespeicher gespeichert wird, wie beispielsweise in der DE10 2022 116 248 B1 offenbart ist. Alternativ kann auch ein Flüssigkeitsspeicher und/oder ein Nah- oder Fernkältenetz zu Kältespeicherung eingesetzt werden. Die zweite Kältespeichervorrichtung 70 ist thermisch mit dem Kältereservoir 56 und/oder dem Kältereservoir 57 gekoppelt und kann insbesondere in der kalten Jahreszeit Kälte zur Rückkühlung des Adsorbers Ads und/oder des Kondensators K speichern.

Die Funktionsweise des erfindungemäßen System zur Kühlung eines Rechenzentrums wird im Folgenden anhand der Figuren 2 bis 5 erläutert.

Wie in Figur 2 gezeigt ist, wird Arbeitsmedium, beispielsweise Wasser, in der Adsorbereinrichtung Ads an einem festen Adsorbens adsorbiert. Hierdurch geht das Arbeitsmedium im Verdampfer V in einen gasförmigen Zustand über. Der Verdampfer V nimmt dabei Wärme aus dem Funktionsmodul 20 auf und betreibt damit den Niedertemperaturkühlkreis 21,41, mit welchem das Funktionsmodul 20 des Rechenzentrums gekühlt wird. Der Wärmefluss vom Funktionsmodul 20 zum Verdampfer V ist durch den Pfeil "W" symbolisiert.

Parallel wird das Arbeitsmedium aus dem Desorber Des durch Zufuhr externer Wärme (Pfeil "W") von dem Prozessormodul 10 über den Hochtemperaturkühlkreis 11, 31, 32 und/oder von der Solarthermieheizung ST ausgetrieben. Das Arbeitsmedium gelangt dann im gasförmigen Zustand zum Kondensator K und wird dort verflüssigt. Dabei gibt das Arbeitsmedium die am Verdampfer aufgenommene Wärme zusammen mit der am Desorber Des zugeführten Wärme (Pfeil "W") am Kondensator K wieder ab, welche mittels eines Wärmetauschers 51 wiederum an ein beispielsweise durch einen Wassertank oder dgl. gebildetes Kältereservoir 56 abgegeben wird. Das Arbeitsmedium gelangt dann über einen Rücklauf 65 in flüssiger Form in den Verdampfer V zurück. Damit schließt sich der Arbeitskreislauf der Adsorptionswärmepumpe.

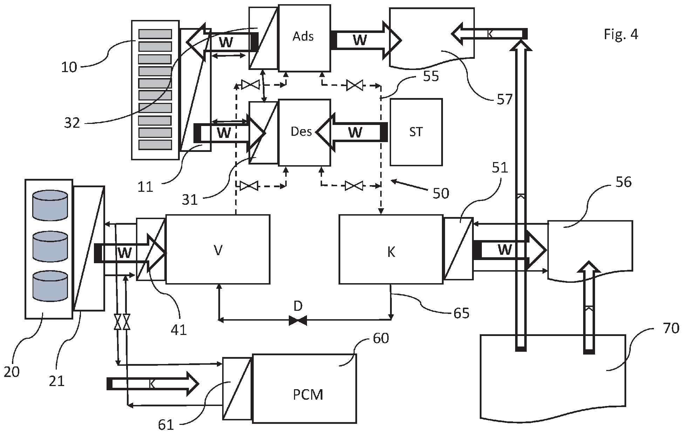

Ist der Adsorber Ads mit dem Arbeitsmedium gesättigt, erfolgt die Umschaltung in den zweiten Teil des Arbeitszyklus, der in Figur 4 illustriert ist.

Durch Öffnen bzw. Schließen der dargestellten Ventile wird wie anhand der Figur 2 erläutert der bisherige Adsorber Ads zum Desorber Des und umgekehrt. Dadurch dreht sich auch der Wärmefluss im Hochtemperaturkühlkreis 11, 31, 32 um, wie wiederum durch die Pfeile "W" und "K" illustriert ist.

Fällt beispielsweise die Rücklauftemperatur im Niedertemperatur-Kühlkreis 21, 41 unter ein bestimmtes Niveau, weil beispielsweise nicht die gesamte Kühlleistung des Verdampfers V benötigt wird, kann ein Teil der erzeugten Kälte im PCM Kältespeicher effizient und raumsparend gespeichert werden, wie in Figur 4 schematisch illustriert ist. Wenn umgekehrt die erforderliche Rückkühlleistung des Kältereservoirs 56 nicht ausreicht, kann über den Wärmetauscher 61 vom PCM Kältespeicher 60 Kälte "entnommen" werden. Durch diese bei Bedarf aus dem PCM Kältespeicher abrufbare zusätzliche Kühlleistung kann die Leistungsfähigkeit und damit die Kosten der gesamten Kühlanlage geringer ausgelegt werden. Außerdem kann die Leistung des Kühlsystems auch im Falle kurzfristig steigender Strompreise heruntergefahren werden und umgekehrt der Kältespeicher in Zeiten niedriger Strompreise wieder aufgefüllt werden.

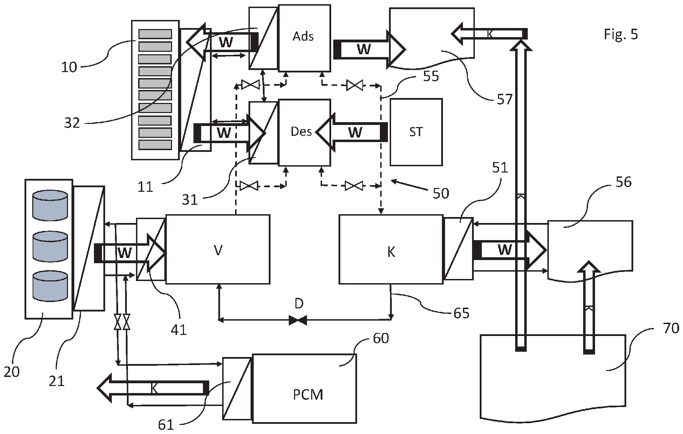

Hierbei zeigt Figur 4 schematisch das Einspeichern von Kälte (Pfeil "K") in den PCM Kältespeicher 60 und Figur 5 die Entnahme von Kälte (Pfeil "K") aus dem PCM Kältespeicher 60, um die Kühlung des Funktionsmoduls 20 zu unterstützen und damit die Kühlleistung des Gesamtsystems zu erhöhen.

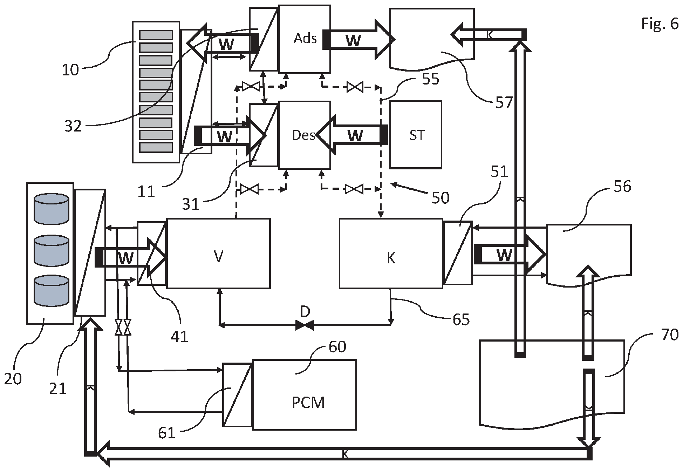

Figur 6 zeigt die Funktion des zweiten Kältespeichers 70, der insbesondere im "Winterbetrieb" zur Kühlung des Funktionsmoduls 20 und/oder der Kältereservoire 56 und 57 eingesetzt werden kann. Dabei wird Umgebungskälte mittels des Gebäudekernspeichers, Flüssigkeitskältespeichers, und/oder des Nah- oder Fernkältenetz in Abhängigkeit von der Außentemperatur thermisch mit den Kältereservoiren 56 und 57 und/oder direkt mit dem Wärmetauscher 21 des Funktionsmoduls 20 gekoppelt werden. Dadurch kann beispielsweise in einem Winterbetrieb ein erheblicher Teil der Kühlleistung durch Umgebungskälte erbracht werden, was eine Verringerung des Kühlenergieverbrauchs des Rechenzentrums ermöglicht. Zusammenfassend erlaubt das erfindungsgemäße System die effiziente Kühlung eines Rechenzentrums wie beispielsweise eines Kl-Rechenzentrums. Die Hochtemperatur-Abwärme der Hochleistungsbauelemente kann effizient zum Betrieb der Adsorptionskühlvorrichtung verwendet werden und der effiziente PCM Kältespeicher ermöglicht durch die Pufferung und Rückgewinnung von Kälteleistung in Spitzenlastzeiten eine Reduzierung der Maximal-Kühlleistungsspezifikation und damit der Kosten der Gesamtkühlanlage, ohne dass die 100% Verfügbarkeit des Rechenzentrums gefährdet wird.

### Bezugszeichenliste:

- Ads: Adsorber
- Des: Desorber
- V: Verdampfer
- K: Kondensator
- D: Drossel
- PCM: PCM-Kältespeicher
- ST: Solarthermische Anlage
- 10: Rechnermodul
- 11: Wärmetauscher
- 20: Funktionsmodul
- 21: thermischen Schnittstelle
- 31: Wärmetauscher
- 31a: Adsorptionskaskade
- 32: Wärmetauscher
- 32a: Adsorptionskaskade
- 41: thermischen Schnittstelle
- 50: Adsorptionskühlvorrichtung
- 51: Wärmetauscher
- 55: Gaskreislauf der Adsorptionskühlvorrichtung
- 56: Kältereservoir
- 60: Kältespeichereinrichtung
- 61: Wärmetauscher
- 65: Flüssigkeitskreislauf der Adsorptionskühlvorrichtung
- 70: Kältespeichervorrichtung

## Patentansprüche

1. System zur Kühlung eines Rechenzentrums, welches eine Vielzahl von Rechnermodulen (10) mit Halbleiterbauelementen aufweist, welche Halbleiterbauelemente im Betrieb eine Wärmequelle darstellen, aufweisend:
eine Kühleinrichtung zur Kühlung der Rechnermodule (10) mittels eines Kühlmittelfluidkreislaufs, wobei die Kühleinrichtung eine Adsorptionskühlvorrichtung (50) mit einem Verdampfer (V), einem Kondensator (K) und einem oder mehreren Adsorptions-/Desorptionselementen (Ads/Des) für das Kühlmittelfluidum aufweist, wobei der Kondensator (K) eine thermische Schnittstelle (51) zur Abgabe von Wärme an ein thermisches Reservoir (56) aufweist, und
eine Kältespeichereinrichtung (60), die steuerbar thermisch mit der Adsorptionskühlvorrichtung (50) zur Pufferspeicherung von von der Adsorptionskühlvorrichtung (50) abgegebener Kälte gekoppelt ist.

2. System nach Anspruch 1, wobei die Kältespeichervorrichtung (60) einen PCM (phase change material) Kältespeicher aufweist.

3. System nach Anspruch 1, wobei das thermische Reservoir (56) der Adsorptionskühlvorrichtung (50) thermisch mit einer zweiten Kältespeichervorrichtung (70) gekoppelt ist.

4. System nach Anspruch 3, wobei die zweite Kältespeichervorrichtung (70) einen Erdkältespeicher, einen thermischen Gebäudekernspeicher, einen Flüssigkeitskältespeicher, und/oder ein Nah- oder Fernkältenetz umfasst.

5. System nach Anspruch 4, wobei der Erdkältespeicher, thermische Gebäudekernspeicher, Flüssigkeitskältespeicher, und/oder das Nah- oder Fernkältenetz in Abhängigkeit von der Außentemperatur thermisch mit dem thermischen Reservoir (56) und/oder der Adsorptionskühlvorrichtung (50) koppelbar ist.

6. System nach einem der Anspruch 1, wobei die Adsorptions-/Desorptionselemente (Ads/Des) der Adsorptionskühlvorrichtung (50) regelbar thermisch mit einer solarthermischen Heizvorrichtung (ST) zur thermischen Unterstützung des Desorptionsvorgangs gekoppelt sind.

7. System nach Anspruch 6, wobei die solarthermische Heizvorrichtung (ST) konfigurierbar ist, in Abhängigkeit von der Außentemperatur in einem Kühlmodus als Kältequelle zu arbeiten.

8. System nach Anspruch 7, wobei die solarthermische Heizvorrichtung (ST) im Kühlmodus thermisch mit dem Adsorber (Ads) und/oder dem Kältereservoir (56) koppelbar ist.

9. System nach Anspruch 1, wobei die Adsorptions-/Desorptionselemente (Ads/Des) der Adsorptionskühlvorrichtung (50) thermisch mit den Rechnermodulen (10) des Rechenzentrums gekoppelt sind, wobei die von den Rechnermodulen (10) abgegebene Wärme zur Desorption des Kühlmittelfluids eingesetzt wird.

10. System nach Anspruch 9, wobei die Adsorptions-/Desorptionselemente (Ads/Des) der Adsorptionskühlvorrichtung (50) mittels Wärmetauschern (11, 31, 32) über einen Hochtemperaturkühlkreislauf thermisch mit den Rechnermodulen (10) des Rechenzentrums gekoppelt sind, wobei die Temperatur des von den Rechnermodulen (10) zum Adsorptionselement Ads zurückfließenden Wärmeaustauschmediums wenigstens 50⁰C, vorzugsweise wenigstens 55°C, und noch bevorzugter wenigstens 60⁰C beträgt.

11. System nach Anspruch 9, wobei für einen kontinuierlichen Kühlbetrieb wenigstens zwei Adsorptions- und Desorptionselemente (Ads/Des) der Adsorptionskühlvorrichtung (50) im Wechsel zyklisch thermisch mit den Rechnermodulen (10) des Rechenzentrums koppelbar sind.

12. System nach Anspruch 1, wobei die Adsorptions-/Desorptionselemente (Ads/Des) der Adsorptionskühlvorrichtung (50) eine temperaturabhängig zwischen Reihen- und Parallelschaltung umschaltbare Adsorptionskaskade 31a, 32a aufweisen.

13. System nach Anspruch 1 12, wobei der Verdampfer (V) der Adsorptionskühlvorrichtung (50) über einen Niedrigtemperaturkühlkreislauf thermisch mit Funktionsmodulen (20) des Rechenzentrums gekoppelt sind, die eine niedrigere Arbeitstemperatur als die Rechnermodule (10) aufweisen.

14. System nach Anspruch 13, wobei die Funktionsmodule (20) Speicherbauelemente und/oder Netzwerkkomponenten des Rechenzentrums enthalten.

15. System nach Anspruch 1, wobei das Kühlmittelfluid der Adsorptionskühlvorrichtung (50) Wasser ist.

16. System nach Anspruch 1, wobei das Sorptionsmittel der Adsorptionskühlvorrichtung (50) Zeolith oder Silikagel ist.

17. System nach Anspruch 1, wobei das PCM-Material des PCM Kältespeichers (60) Wasser, Salzlösungen oder Paraffine enthält.

18. System nach Anspruch1, wobei das Rechenzentrum ein Kl-Rechenzentrum ist und die Halbleiterbauelemente der Rechnermodule für Kl-Anwendungen eingerichtete GPU- oder CPU-Chips sind.

19. Rechenzentrum aufweisend ein Kühlsystem nach Anspruch 1.
